# EUROPEAN PATENT SPECIFICATION

(11) **EP 1 570 606 B1**
(45) Date of publication and mention of the grant of the patent: **16.08.2006**
(21) Application number: 02786808.2
(22) Date of filing: 26.11.2002
(51) Int. Cl.: H04L 12/56, H03M 13/09, H04L 7/04

(54) **PREAMBLE DETECTION AND DATA RATE CONTROL IN A COMMUNICATION SYSTEM**
PRÄAMBELDETEKTION UND DATENRATENSTEUERUNG IN EINEM KOMMUNIKATIONSSYSTEM
DETECTION DE PREAMBULES ET COMMANDE DE DEBIT DE DONNEES DANS UN SYSTEME DE COMMUNICATION

(43) Date of publication of application: 07.09.2005
(73) Proprietor: QUALCOMM INCORPORATED, San Diego, California 92121 (US)
(72) Inventor: EKVETCHAVIT, Thunyachate, San Diego, CA 92108 (US); SINDHUSHAYANA, Nagabhushana, T., San Diego, CA 92129 (US); GURELLI, Mehmet, San Diego, CA 92122 (US); BLACK, Peter, J., San Diego, CA 92103 (US)
(74) Representative: Hess, Peter K. G.
(86) International application number: PCT/US2002/038041
(87) International publication number: WO 2004/049652

(56) References cited:
- EP-A- 0 372 473
- EP-A- 1 119 118
- EP-A- 1 178 638
- WO-A-01/89162
- US-A- 5 668 810
- US-A- 5 898 684
- US-A1- 2001 053 140

## Description

### Field

The present invention relates generally to the field of communications, and more particularly, to data communications in a communication system.

### Background

In a communication system, unnecessary and excessive transmissions by a user may cause interference for other users in addition to reducing the system capacity. The unnecessary and excessive transmission may be caused by inefficient flow of data in the communication system. The data communicated between two end users may pass through several layers of protocols for assuring proper flow of data through the system. The proper delivery of data in at least one aspect is assured through a system of checking for error in each packet of data, and requesting a retransmission of the same packet of data if an unacceptable error is detected in the packet of data. A packet of data may be transmitted over several time slots. Each time slot is transmitted over the air, for example, from a base station to a mobile station. The first time slot may contain preamble data. The preamble data is predetermined. The data transmitted to a receiving station, such as a mobile station, is encoded with a code assigned to the receiving station. The preamble is also encoded with the assigned code. Several mobile stations in a communication system may be in an operating state that requires the mobile stations to monitor each received time slot. The mobile stations decode the received data in each time slot; and based on the decoded results, each mobile station decides whether the transmitted data is destined for the mobile station. The mobile stations, at first, look for detection of the preamble. Since each mobile, station is assigned a unique code, only the destination mobile station is expected to detect the preamble. If a mobile station detects a preamble, the mobile station continues to decode the data following the preamble in the first time slot. If the data is transmitted over several time slots, the mobile station continues to decode the data in other time slots. The time slots after the first time slot do not have preamble data. The mobile station terminates the search for detecting a preamble after detecting a preamble until at least the transmitted packet of data is received over one or more expected time slots. However, a mobile station may falsely detect a preamble. The false detection of the preamble may be due to many reasons. After a false detection of the preamble, if a preamble is transmitted to the mobile station, the mobile station fails to detect the preamble because the mobile station does not look for another preamble immediately. As a result, the base station may unnecessarily repeat transmissions of data over the air, causing unnecessary interference and reducing system capacity, and transmission of data to the mobile station may be delayed.
From the EP 1 119 118 A2 a method for controlling a random access to a base station in a CDMA communication system is known. It provides a CDMA mobile communication system with a random access control method and a base station to reduce the probability of failing to detect the preamble. The preamble detector measures the signal-to-interference power ratio of a received preamble after RAKE combining and makes a decision on whether to authorize a mobile station to transmit a message by comparing the detection result with a threshold value.
Furthermore, the EP 1 178 638 A1 relates to a preamble receiving device and preamble receiving method. Correlation values are calculated by coherent detection and non-coherent detection. Based on these values, a threshold determining section recognizes that a preamble generated and sent by a communication terminal apparatus has been received.
Finally, the US 5,898,684 decribes a TDMA burst receiver and a method for recognizing and providing a time-of-arrival of a TDMA burst transmission having a selected preamble.

Each mobile station communicates a data rate control (DRC) information to the base station for indicating the data rate that the mobile station can support on the forward link. The DRC data is continuously updated by the mobile station based on the received data error rate to allow the base station to transmit the data packets at an optimum data rate on the forward link to the mobile station. In case of a false detection of preamble, the decoded data after the false preamble detection is erroneous. The erroneous data does not allow the cyclic redundancy check (CRC) to pass. As a result, the mobile station may inform the base station that the mobile station is capable of supporting communications at a lower data rate than the actual optimum data rate, resulting in inefficient use of the communication resources. Therefore, there is a need to resolve CRC failure in case of false detection of preamble.

### SUMMARY

The invention is defined in independent claims 1 and 7.

A system and various methods and apparatus for efficient detection of a packet of data in a communication system. The method and apparatus for detecting a packet of data includes a control system incorporated in a receiver system for determining a current preamble threshold for a current time slot associated with reception of the packet of data. The receiver system determines a current preamble metric associated with decoding energy of a preamble of the packet of data in the current time slot, and determines whether a preamble is detected by comparing the current metric to the current preamble threshold. If a preamble is detected, the system determines whether an earlier preamble has been detected in an earlier time slot having a common time slot interlace index. If an earlier preamble is detected, the system resolves multiple detections of a preamble based on at least one of the current preamble threshold, an old preamble threshold, the current preamble metric, and an old preamble metric. The old preamble threshold and the old preamble metric are associated with the earlier preamble detection.

In another aspect, if a preamble is detected and selected, the receiver system decodes data following the selected preamble and determines the CRC of the decoded data. If a CRC failure is detected, the receiver determines a new current preamble threshold. The new current preamble threshold is larger than the current preamble threshold. If the current preamble metric is larger than the new current preamble threshold, the receiver determines the CRC failure as an actual CRC failure, otherwise as a false CRC failure.

### BRIEF DESCRIPTION OF THE DRAWINGS

The features, objects, and advantages of the present invention will become more apparent from the detailed description set forth below when taken in conjunction with the drawings in which like reference characters identify correspondingly throughout and wherein:

FIG. 1 depicts a communication system for implementing various aspects of the invention;

FIG. 2 depicts a time slot structure for transmission of data and for implementing various aspects of the invention;

FIG. 3 depicts a table of various parameters used for transmission of data and for implementing various aspects of the invention;

FIG. 4 depicts transmission of data in accordance with a time slot interlace index for implementing various aspects of the invention;

FIG. 5 depicts a receiver system for operation in accordance with various aspects of the invention;

FIG. 6 depicts a transmitter system for operation in accordance with various aspects of the invention;

FIG. 7 depicts a transceiver system for operation in accordance with various aspects of the invention;

FIG. 8 depicts a flow chart outlining various steps for implementing various aspects of the invention for resolving multiple detection of a preamble; and

FIG. 9 depicts a flow chart outlining various steps for implementing various aspects of the invention for determining a false CRC failure.

### Detailed Description of the Preferred Embodiment(s)

Generally stated, a novel and improved method and apparatus provide for efficient use of communication resources in a communication system. In at least one aspect, the receiving station continues to decode the received data to monitor for reception of preamble, even if a preamble has been received previously. After detecting a second preamble, the receiving station resolves multiple detections of preamble. The receiving station resolves multiple detections of preamble based on a current preamble threshold used for the latest detection of preamble, the old preamble threshold used to detect the previously received preamble, the current preamble metric determined for the last preamble, and the old preamble metric determined for the previously detected preamble. The receiving station may be a mobile station in a communication system. One or more exemplary embodiments described herein are set forth in the context of a digital wireless data communication system. While use within this context is advantageous, different embodiments of the invention may be incorporated in different environments or configurations. In general, the various systems described herein may be formed using software-controlled processors, integrated circuits, or discrete logic. The data, instructions, commands, information, signals, symbols, and chips that may be referenced throughout the application are advantageously represented by voltages, currents, electromagnetic waves, magnetic fields or particles, optical fields or particles, or a combination thereof. In addition, the blocks shown in each block diagram may represent hardware or method steps.

More specifically, various embodiments of the invention may be incorporated in a wireless communication system operating in accordance with the code division multiple access (CDMA) technique which has been disclosed and described in various standards published by the Telecommunication Industry Association (TIA) and other standards organizations. Such standards include the TIA/EIA-95 standard, TIA/EIA-IS-2000 standard, IMT-2000 standard, UMTS and WCDMA standard. A system for communication of data is also detailed in the "TIA/EIA/IS-856 cdma2000 High Rate Packet Data Air Interface Specification". A copy of the standards may be obtained by accessing the world wide web at the address: http://www.3gpp2.org, or by writing to TIA, Standards and Technology Department, 2500 Wilson Boulevard, Arlington, VA 22201, United States of America. The standard generally identified as UMTS standard may be obtained by contacting 3GPP Support Office, 650 Route des Lucioles-Sophia Antipolis, Valbonne-France.

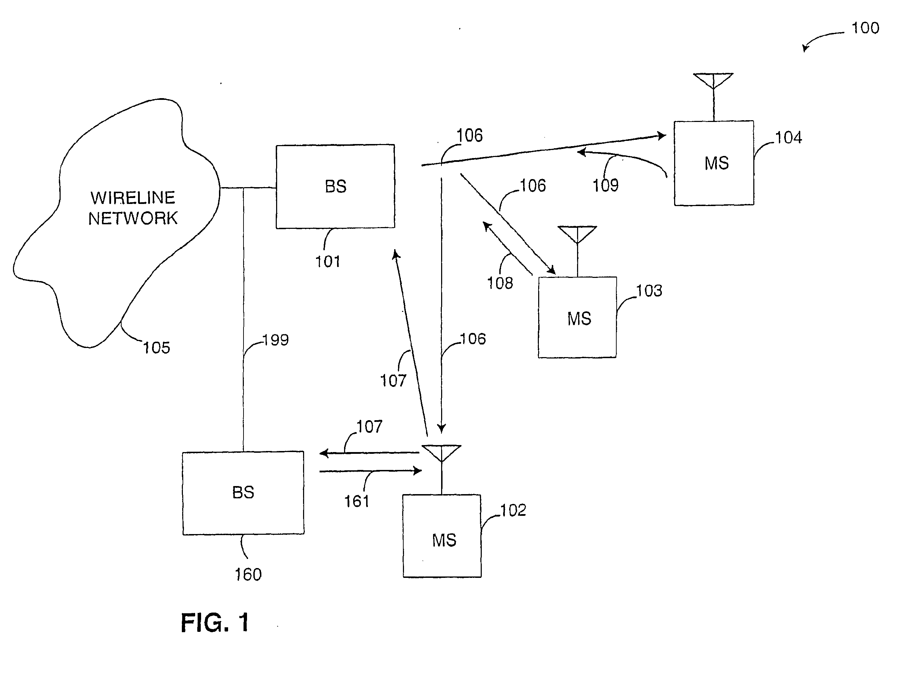

FIG. 1 illustrates a general block diagram of a communication system 100 capable of operating in accordance with any of the code division multiple access (CDMA) communication system standards while incorporating various embodiments of the invention. Communication system 100 may be for communications of voice, data or both. Generally, communication system 100 includes a base station 101 that provides communication links between a number of mobile stations, such as mobile stations 102-104, and between the mobile stations 102-104 and a public switch telephone and data network 105. The mobile stations in FIG. 1 may be referred to as data access terminals (AT) and the base station as a data access network (AN) without departing from the main scope and various advantages of the invention. Base station 101 may include a number of components, such as a base station controller and a base transceiver system. For simplicity, such components are not shown. Base station 101 may be in communication with other base stations, for example base station 160. A mobile switching center (not shown) may control various operating aspects of the communication system 100 and in relation to a back-haul 199 between network 105 and base stations 101 and 160.

Base station 101 communicates with each mobile station that is in its coverage area via a forward link signal transmitted from base station 101. The forward link signals targeted for mobile stations 102-104 may be summed to form a forward link signal 106. Each of the mobile stations 102-104 receiving forward link signal 106 decodes the forward link signal 106 to extract the information that is targeted for its user. Base station 160 may also communicate with the mobile stations that are in its coverage area via a forward link signal transmitted from base station 160. Mobile stations 102-104 communicate with base stations 101 and 160 via corresponding reverse links. Each reverse link is maintained by a reverse link signal, such as reverse link signals 107-109 for respectively mobile stations 102-104. The reverse link signals 107-109, although may be targeted for one base station, may be received at other base stations.

Base stations 101 and 160 may be simultaneously communicating to a common mobile station. For example, mobile station 102 may be in close proximity of base stations 101 and 160, which can maintain communications with both base stations 101 and 160. On the forward link, base station 101 transmits on forward link signal 106, and base station 160 on the forward link signal 161. On the reverse link, mobile station 102 transmits on reverse link signal 107 to be received by both base stations 101 and 160. For transmitting a packet of data to mobile station 102, one of the base stations 101 and 160 may be selected to transmit the packet of data to mobile station 102. On the reverse link, both base stations 101 and 160 may attempt to decode the traffic data transmission from the mobile station 102. The data rate and power level of the reverse and forward links may be maintained in accordance with the channel condition between the base station and the mobile station.

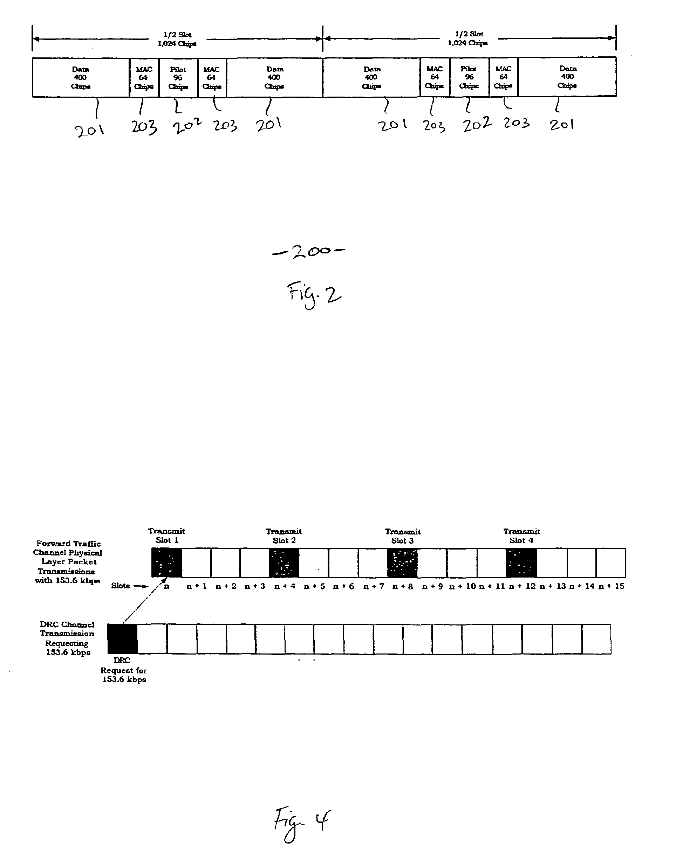

FIG. 2 illustrates a forward link time slot structure 200 that may be used for communications on the forward link to each mobile station in the communication system 100. Each time slot may have 2048 chips. One half of a slot time may have 1024 chips. Each half slot has two traffic data fields 201. Each traffic data 201 field may have 400 chips. Each half slot also has a pilot data field 202. The pilot data field 202 may have 96 chips. Each half slot also has two control data fields 203. During idle time, the traffic data fields 201 carry no data. The pilot data field 202 and control data field 203 carry respectively pilot data and control data.

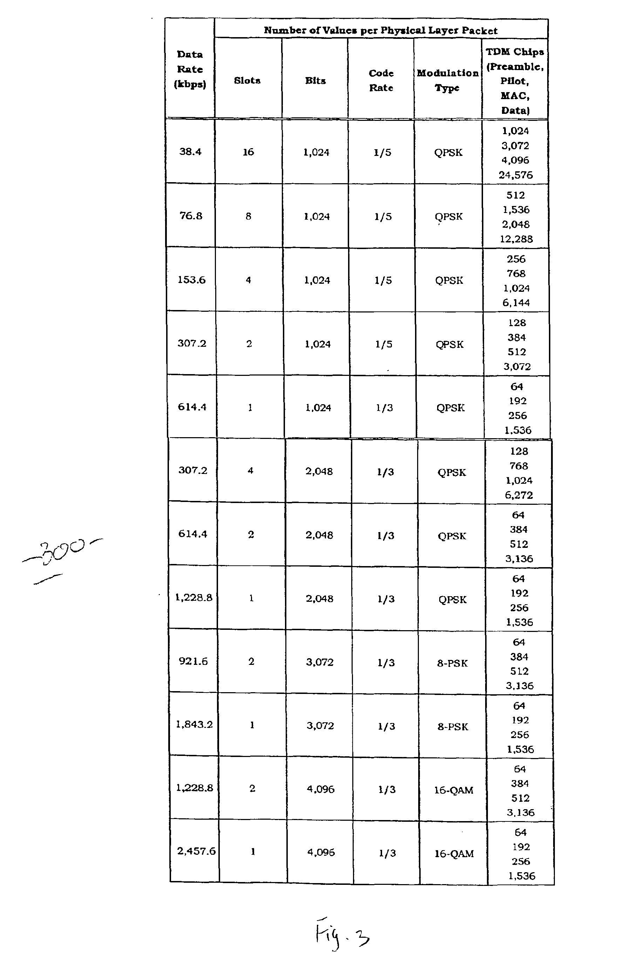

The mobile stations in communication system 100 communicate a data rate control (DRC) information to the base stations. The DRC information indicates a requested communication data rate for the traffic data on the forward link for each mobile station. The DRC information may indicate one out 12 possible data rates. Referring to FIG. 3, a table 300 illustrates the possible data rates. Each data rate has an associated modulation type, encoding rate and the number of slots used to transmit a packet of data. For example, for data rate 153.6 kbps, four time slots are used to transmit one packet of data. The first time slot used to transmit the packet of data carries the preamble data. The number of chips in the preamble depends on the transmission data rate. The number of chips in the preamble for data rate 153.6 kbps is set at 256 chips. The preamble data is transmitted in the traffic data field 201. After transmitting the preamble, the traffic data is followed. The transmission of the traffic data continues for the remaining traffic data field 201 in all four time slots.

The data packet is transmitted to the mobile station over the number of time slots indicated by the DRC information in table 300. The transmission of the time slots is interlaced. Referring to FIG. 4, the transmission of time slots for data rate 153.6 kbps is shown as an example. For example, the four time slots are transmitted over time slots "n, n+4, n+8, and n+12". The mobile station may not know when the first time slot, the time slot "n", used for transmission of a packet of data is transmitted. As a result, when the receiving station detects a preamble in time slot "n", and in accordance with the example the data rate is 153. 6 kbps, the receiver continues decoding data in time slots "n+4, n+8, and n+12". Detection of the preamble is an indication of the beginning of transmission of a packet of data. In accordance with prior art, the receiving station does not monitor the time slots "n+4, n+8, and n+12" for detection of a preamble, since a preamble has been detected in time slot "n". In accordance with various aspects of the invention, and in accordance with the example for the data rate 153. 6 kbps, the receiving station monitors the time slots "n+4, n+8, and n+12" for detection of a preamble, even after detecting a preamble in time slot "n". If a second preamble is detected in time slots "n+4, n+8, or n+12", the receiving station resolves multiple detections of a preamble in accordance with various aspects of the invention. If the first preamble is selected as the real preamble and the second preamble as the erroneous preamble, the receiving station ignores the second preamble and continues demodulating the data following the first preamble. If the second preamble is selected as the real preamble and the first preamble as the erroneous preamble, the receiving station ignores the ongoing data demodulation from the first preamble and starts decoding the traffic data followed the second preamble. In such a case, the receiving station abandons monitoring time slots "n+4, n+8, or n+12" for decoding the traffic data.

The transmission of data to the mobile station may be in accordance with any time slot interlace index. For example, if an interlace index "n" is chosen, and in accordance with the example for data rate 153.6 kbps, the data is communicated on time slots "n, n+4, n+8 and n+12". If an interlace index "n+1" is chosen, the data is communicated on time slots "n+1, n+5, n+9 and n+13". Each preamble is associated with a time slot interlace index. If a preamble is detected at the time slots occurring between time slots "n, n+4, n+8 and n+12", the detected preamble is associated with another time slot interlace index than the interlaced index "n", for example. The mobile station receiver may be looking for preamble in every time slots. If a second preamble is detected, the second preamble should have the same interlace index to resolve multiple detections of preamble in accordance with various aspects of the invention. Only if the first and second detected preambles have the same interlace index, the receiving station resolves multiple detections of preamble based on a current preamble threshold used for the latest detection of preamble, the old preamble threshold used to detect the previously received preamble, the current preamble metric determined for the last preamble, and the old preamble metric determined for the previously detected preamble. The previously received preamble is the first preamble and the current preamble is the second preamble.

Each data rate has an associated preamble length. Referring to FIG. 3, table 300 indicates, for example, a preamble length of 1024 chips long for data rate 38.4 kbps and 64 chips long for data rate 2457.6 kbps. Detection of the preamble involves accumulating decoded energy over the expected number of preamble chips. The accumulated energy is translated into a metric. The metric is compared to a preamble threshold. If the metric is larger than the preamble threshold, the receiving station declares detection of a preamble. The preamble threshed is different for different lengths of preamble. In one aspect, the preamble threshold is proportional to the signal to noise ratio of pilot data detected by the receiving station. The receiving station monitors the pilot data during the pilot data field 202, and determines a signal to noise ratio of the channel. The signal to noise ratio is lower for weak channel than strong channel conditions. As a result, the preamble threshold is based on the channel condition in addition to the expected length of preamble. The expected length of preamble is based on the data rate. The channel condition may change from one time slot to the next. As a result, the preamble threshold used in one slot may be different in the next time slot even though the expected length of preamble is the same. In one aspect, the receiving station may use a current preamble threshold that is different than the old preamble threshold used for detecting the last preamble. The old preamble detection is based on comparing the old preamble metric to the old preamble threshold. The current preamble threshold is compared to a current preamble metric for determining whether a new preamble is detected. For example, if a preamble is detected during time slot "n", associated with time slot interlace index "n", such a preamble detection is considered an old preamble detection when a new preamble is detected during time slot "n+4", associated with the same time slot interlace index "n". The preamble detection during time slot "n+4" is the current preamble detection, and the preamble detected during time slot "n" becomes the old preamble detection. As such, the preamble threshold used during time slot "n" is the old preamble threshold. The preamble metric determined during time slot "n" is the old preamble metric. The preamble threshold used during time slot "n+4" is the current preamble threshold.

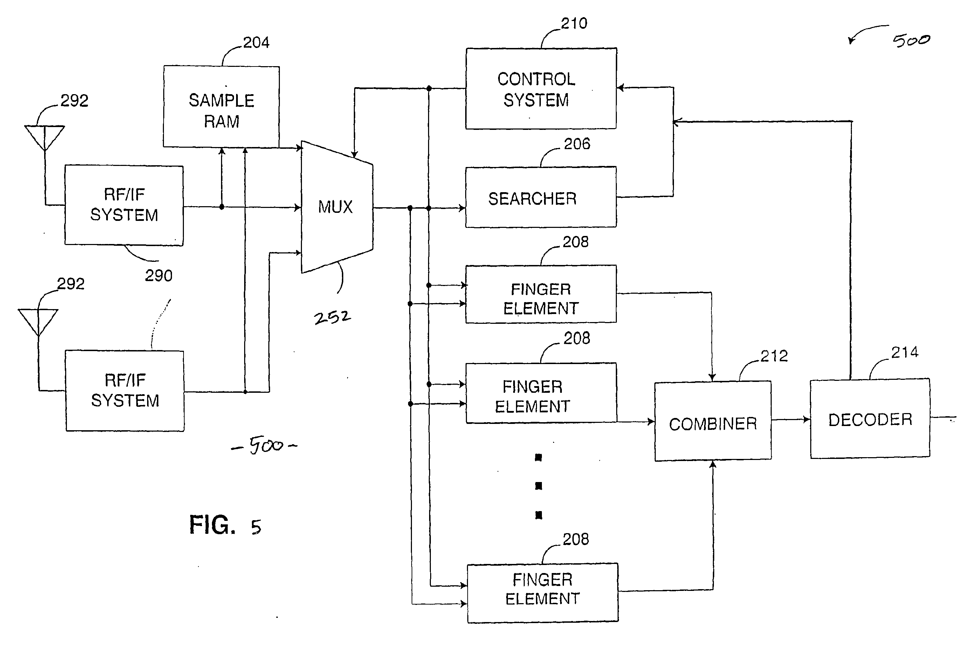

FIG. 5 illustrates a block diagram of a receiver 500 used for processing and demodulating the received CDMA signal while operating in accordance with various aspects of the invention. Receiver 500 may be used for decoding the information on the reverse and forward links signals. Receiver 500 in a mobile station may be used for detection of preamble, decoding pilot data, traffic data and the control data transmitted from a base station. Received (Rx) samples may be stored in RAM 204. Receive samples are generated by a radio frequency/intermediate frequency (RF/IF) system 290 and an antenna system 292. The RF/IF system 290 and antenna system 292 may include one or more components for receiving multiple signals and RF/IF processing of the received signals for taking advantage of the receive diversity gain. Multiple received signals propagated through different propagation paths may be from a common source. Antenna system 292 receives the RF signals, and passes the RF signals to RF/IF system 290. RF/IF system 290 may be any conventional RF/IF receiver. The received RF signals are filtered, down-converted and digitized to form RX samples at base band frequencies. The samples are supplied to a multiplexer (mux) 252. The output of mux 252 is supplied to a searcher unit 206 and finger elements 208. A control unit 210 is coupled thereto. A combiner 212 couples a decoder 214 to finger elements 208. Control unit 210 may be a microprocessor controlled by software, and may be located on the same integrated circuit or on a separate integrated circuit. The decoding function in decoder 214 may be in accordance with a turbo decoder or any other suitable decoding algorithms.

During operation, received samples are supplied to mux 252. Mux 252 supplies the samples to searcher unit 206 and finger elements 208. Control unit 210 configures finger elements 208 to perform demodulation and despreading of the received signal at different time offsets based on search results from searcher unit 206. The results of the demodulation are combined and passed to decoder 214. Decoder 214 decodes the data and outputs the decoded data. Despreading of the channels is performed by multiplying the received samples with the complex conjugate of the PN sequence and assigned Walsh function at a single timing hypothesis and digitally filtering the resulting samples, often with an integrate and dump accumulator circuit (not shown). Such a technique is commonly known in the art. Receiver 500 may be used in a receiver portion of base stations 101 and 160 for processing the received reverse link signals from the mobile stations, and in a receiver portion of any of the mobile stations for processing the received forward link signals.

The decoder 214 accumulates the combined energy for detection of a preamble. If a preamble is detected, the decoder 214 indicates for the control system 210 to continue to monitor the related time slots, in accordance with the same time slot interlace index, for decoding the traffic data followed the detected preamble. When the decoder 214 detects a second preamble with the same time slot interlace index, the decoder 214 in connection with the control system 210 resolve whether the first or the second preamble is the real preamble and the other is an erroneous detection. To resolve multiple detections of preamble, the decision is based on the old preamble threshold and preamble metric and current preamble threshold and preamble metric, in accordance with various aspects of the invention.

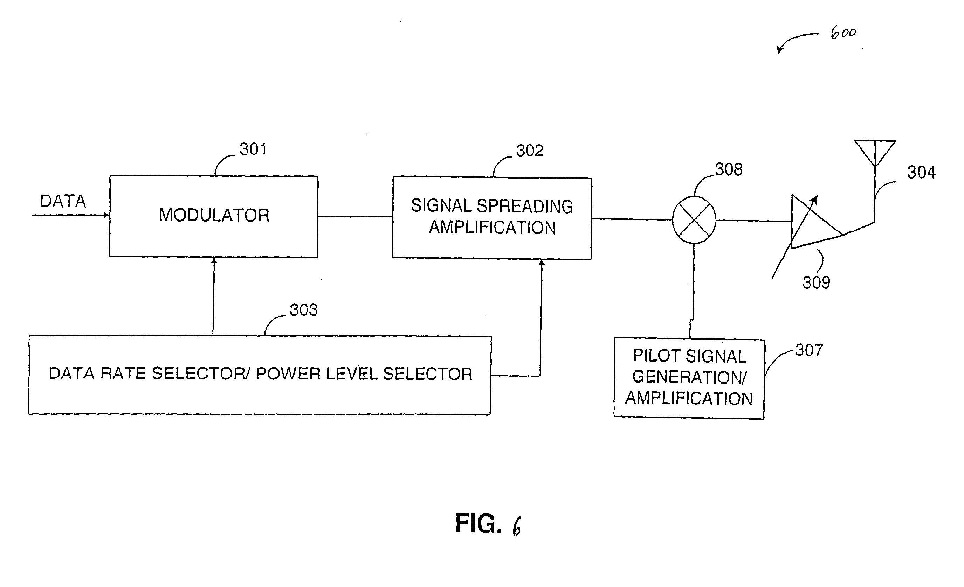

FIG. 6 illustrates a block diagram of a transmitter 600 for transmitting the reverse and forward link signals. Transmitter 600 may be used for transmission of data in accordance with the time slot structure 200 and the parameters shown in table 300 in FIG. 3. The channel data for transmission are input to a modulator 301 for modulation. The modulation may be according to any of the commonly known modulation techniques such as QAM, PSK or BPSK. In case of the forward link, the modulation is selected based on the DRC information. The table 300 indicates the associated modulation. The data is encoded at a data rate in modulator 301. The data rate may be selected by a data rate and power level selector 303. The data rate selection may be based on feedback information received from a receiving destination. The receiving destination may be a mobile station or a base station. The feedback information may include the maximum allowed data rate. The maximum allowed data rate may be determined in accordance with various commonly known algorithms. The maximum allowed data rate very often is based on the channel condition, among other considered factors. For the forward link, the data rate is selected based on the DRC information received from the mobile station. The channel condition may change from time to time. As a result, the selected data rate also changes from time to time accordingly.

The data rate and power level selector 303 accordingly selects the data rate in modulator 301. The output of modulator 301 passes through a signal spreading operation and amplified in a block 302 for transmission from an antenna 304. The data rate and power level selector 303 also selects a power level for the amplification level of the transmitted signal in accordance with the feedback information. The combination of the selected data rate and the power level allows proper decoding of the transmitted data at the receiving destination. A pilot signal is also generated in a block 307. The pilot signal is amplified to an appropriate level in block 307. The pilot signal power level may be in accordance with the channel condition at the receiving destination. The pilot signal may be combined with the channel signal in a combiner 308. The combined signal may be amplified in an amplifier 309 and transmitted from antenna 304. The antenna 304 may be in any number of combinations including antenna arrays and multiple input multiple output configurations. For the forward link, the transmission may formatted to comply with the slot structure shown in FIG. 2. The pilot data for pilot field 202, control data for control field 203, and traffic data for traffic data filed 201 may be formatted at the input of modulator 301. The formatted data is processed through transmitter 600.

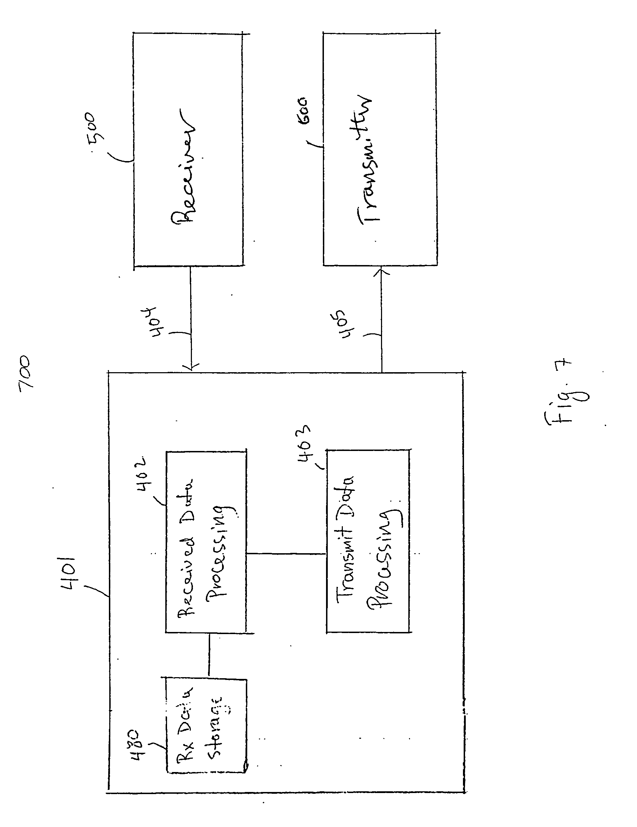

FIG. 7 depicts a general diagram of a transceiver system 700 for incorporating receiver 500 and transmitter 600 for maintaining a communication link with a destination. The transceiver 700 may be incorporated in a mobile station or a base station. The transceiver 700 may be used to resolve multiple detections of preamble data in accordance with various aspects of the invention. A processor 401 may be coupled to receiver 500 and transmitter 600 to process the received and transmitted data. Various aspects of the receiver 200 and transmitter 300 may be common, even though receiver 500 and transmitter 600 are shown separately. In one aspect, receiver 500 and transmitter 600 may share a common local oscillator and a common antenna system for RF/IF receiving and transmitting. Transmitter 600 receives the data for transmission on input 405. Transmit data processing block 403 prepares the data for transmission on a transmit channel. Received data, after being decoded in decoder 214, are received at processor 401 at an input 404. Received data are processed in received data processing block 402 in processor 401. Various operations of processor 401 may be integrated in a single or multiple processing units. Moreover, various operations of processor 401 may be integrated with operations of receiver 500 and transmitter 600. The transceiver 700 may be connected to another device. The transceiver 700 may be an integral part of the device. The device may be a computer or operates similar to a computer. The device may be connected to a data network, such as Internet. In case of incorporating the transceiver 700 in a base station, the base station through several connections may be connected to a network, such as Internet.

The processing of the received data generally includes checking for error in the received packets of data. For example, if a received packet of data has error at an unacceptable level, the received data processing block 402 sends an instruction to transmit data processing block 403 for making a request for retransmission of the packet of data. The request is transmitted on a transmit channel. Moreover, transmit data processing block 403 transmits the DRC information based on inputs from the received data processing block 402. The input information may include the channel condition information and the channel error rate. After detecting a preamble, the processor 401 may store the received data in data storage unit 480 until all the traffic data are received over the subsequent time slots. In case of multiple detections of preamble, the processor 401 may decide that the earlier detection of the preamble has been erroneous. The decision may be based of the old and the current preamble thresholds and preamble metrics. If the second preamble is selected as the real preamble, the processor 401 flushes the stored data associated with the detection of the old preamble.

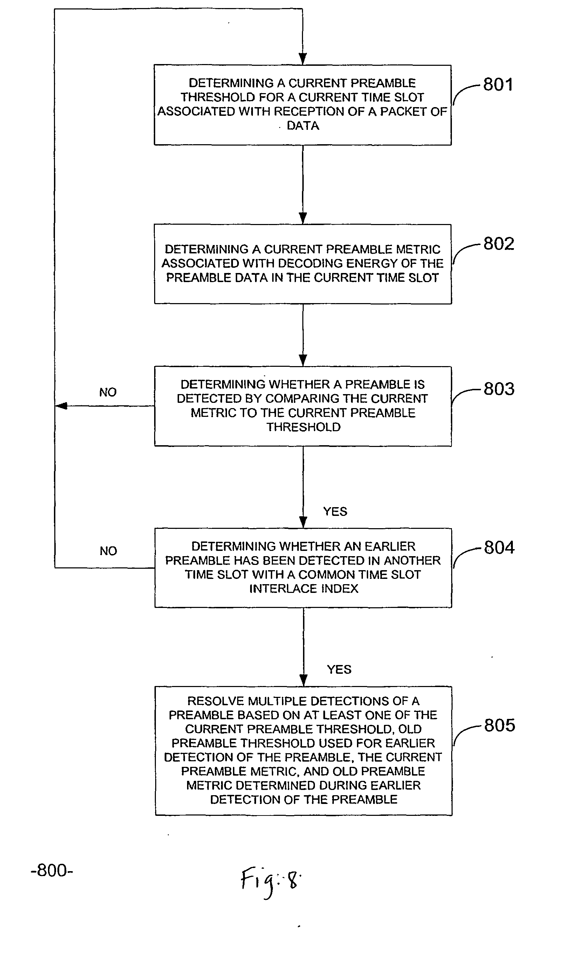

Referring to FIG. 8, a flow chart 800 may be used by transceiver 700 to resolve multiple detections of preamble. The transceiver 700 may be incorporated in a mobile station in communication system 100 and operate in accordance with various aspects of the invention. The base station in communication system 100 transmits on a forward link to the mobile stations. Each mobile station using the transceiver 700 receives the transmissions on the forward link and searches for detection of a preamble in every time slot. The transceiver 700 continues to look for detection of preamble in the time slots "n+1" and onward, even if one has been detected in time slot "n", while referring to FIG. 4. For resolving multiple detections of a preamble, the preambles are detected in time slots that are associated with a common time slot interlace index. For example, a preamble detected in time slot "n" is resolved with a possible detection of preamble in time slots "n+4, n+8 or n+12", in case if the DRC value corresponds to the data rate 153.6 kbps as shown in table 300 in Fig. 3. For the same DRC value, a preamble detected in time slot "n+1" is resolved with a possible detection of preamble in time slots "n+5, n+9 or n+13". At step 801, the transceiver 700 through operations of processor 401 and controller 210 determines a current preamble threshold for a current time slot associated with reception of a packet of data. The current preamble threshold is based on the last DRC information transmitted by transceiver 700. Since for each data rate, there is an associated preamble length, as shown in table 300, the threshold may be different for each data rate. Moreover, the threshold is also based on the current signal to noise ratio. For example, the transceiver 700 determines the signal to noise ratio based on the pilot data received during time slot "n". The signal to noise ratio information and the expected preamble length, determined based on the last communicated DRC value, are used to determine the threshold. If the signal to noise ratio is small, the threshold is also correspondingly small. If the preamble length is small, the threshold is also correspondingly small. At step 802, the transceiver 700 determines a current preamble metric associated with the decoded energy of the preamble in the current time slot. The current preamble metric is an indication of the accumulated preamble energy over the expected length of the preamble during the current time slot. At step 803, the transceiver 700 through processor 401 and controller 210 determines whether a preamble is detected in the current time slot. The current preamble metric is compared to the current preamble threshold. If the current preamble metric is less than the current preamble threshold, the transceiver 700 has not detected a preamble in the current time slot. At this point, the process flow 800 moves to step 801, and transceiver 700 continues to look for detection of preamble in a next time slot. If the current preamble metric is larger than the current preamble threshold, the transceiver 700 has detected a preamble in the current time slot. At this point, the process flow 800 moves to step 804. At step 804, the transceiver 700 through controller 210 and processor 401 determines whether an earlier preamble has been detected in another time slot that is associated with a common time slot interlace index. For example in case of 153.6 kbps, if the current time slot is time slot "n", the next time slot considered for a common time slot interlace index would be any of the time slots "n+4, n+8 or n+12". If the current detection of the preamble is the first preamble detection, the process flow 800 moves to step 801 for transceiver 700 to look for a new preamble in other time slots. If the current detection of the preamble is a second detection of the preamble associated with a common time slot interlace index, the transceiver 700 has detected multiple preambles and the process moves to step 805. At step 805, the transceiver 700 through controller 210 and processor 401 resolves multiple detections of a preamble, and selects one of the detections as the real detection of the preamble and the other one as the false detection. The processor 401 and controller 210 resolves multiple detections of the preamble based on at least one of the current preamble threshold, old preamble threshold, the current preamble metric and the old preamble metric.

In one or more aspects, the resolve function for resolving which preamble detection is the real preamble detection is based on at least one of the current preamble threshold, old preamble threshold, the current preamble metric and the old preamble metric. At first, the processor 401 and control system 210 determine if the values of the old preamble threshold and the current preamble threshold are drastically different. For example, one threshold may be eight times larger than the other threshold. In such a case, the value of one threshold is drastically different than the other one. When the values of the current and old thresholds are drastically different, the resolve function selects the preamble detection associated with the larger preamble threshold as the real preamble detection. If the values of the old and current thresholds are close, for example less than eight times, then the resolve function selects the preamble detection associated with the larger ratio of the preamble metric and the preamble threshold as the real preamble detection. The processor 401 and control system 210 may need to determine the ratio of the preamble metric and the preamble threshold for both the current and the old detections of the preamble.

In case of detecting a false preamble, the traffic data followed the preamble is erroneous. In such a case, the CRC of the transmitted data fails. The receive data processing unit 402 may send a message to the transmit data processing unit 403 to send out a negative acknowledgment indicating erroneous detection of data. At the same time, the processor 401 may assume that the previously determined DRC value may have been overestimated. In such a case, the transceiver 700 may choose a lower data rate after it receives CRC failure at the end of data packet. The lower data rate, which is in reality less than the optimum data rate, is communicated to the transmitting station. In such a case, in accordance with various aspects of the invention, transceiver 700 through controller 210 and processor 401 determines another preamble threshold that is larger than the current preamble threshold. This second preamble threshold may be calculated at the same time as when the current preamble metric is determined. The calculation of the second preamble threshold may not necessarily take place after receiving the CRC failure. For example, for 153.6 kbps, if a preamble detection made at time slot "n" is a false detection, the receiving station may determine a CRC failure at time slot "n+12". The second preamble threshold may be calculated at time slot "n" at the same time as when the preamble is detected. The current preamble metric is compared to the new preamble threshold, i.e. the second preamble threshold. If the current preamble metric is larger than the new current preamble threshold, the CRC failure is an actual CRC failure. If the current preamble metric is not larger than the new current preamble threshold, the CRC failure is not an actual CRC failure, in accordance with various aspects of the invention.

In one aspect, when the preamble threshold is set too high, the probability of missing a preamble is also set too high. In contrast, when the preamble threshold is set too low, the probability of false detection of the preamble increases correspondingly. To lower the probability of missing an actual transmission of preamble, the preamble threshold may be selected at a low level. To resolve the issue with false detection of the preamble and the resulting CRC failure, the current preamble metric is compared to the new preamble threshold. The new preamble threshold is selected at a higher level than the current preamble threshold, in accordance with various aspects of the invention.

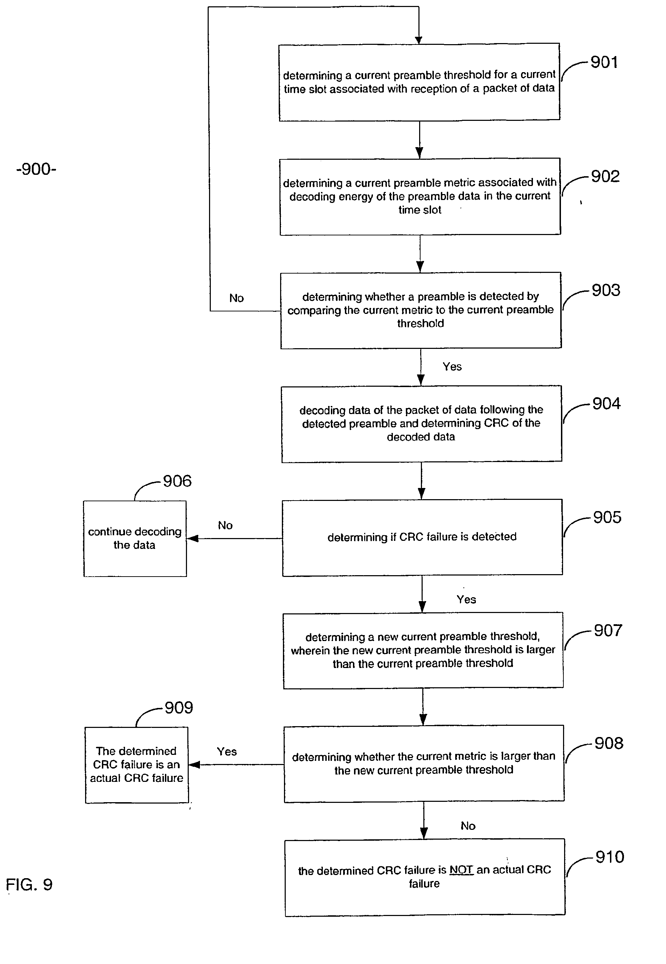

Referring to FIG. 9, a flow chart 900 provides an exemplary flow for transceiver 700 to decide whether a CRC failure is an actual CRC failure or due to false detection of the preamble. At step 901, transceiver 700 determines a current preamble threshold for a current time slot associated with reception of a packet of data. At step 902, the transceiver 700 determines a current preamble metric associated with accumulated decoded energy of the preamble in the current time slot. At step 903, the transceiver compares the current preamble metric to the current preamble threshold to determine whether a preamble is detected. If no preamble is detected, the process flow 900 moves to step 901. If a preamble is detected, the process moves to step 904 for the transceiver 700 to decode the data following the detected preamble, and to determine the CRC of the decoded data. At step 905, the transceiver 700 through controller 210 and processor 401 determines whether a CRC failure is detected. If the CRC failure is not detected, the transceiver 700 at step 906 continues to decode the data. If a CRC failure is detected, the transceiver 700 at step 907 for comparing the preamble metric with a new current preamble threshold, calculates prior to the reception of the end of packet of data the new current preamble threshold. The new current preamble threshold is set larger than the current preamble threshold determined at step 901. At step 908, the transceiver 700 determines whether the current metric is larger than the new current preamble threshold. If the current preamble metric is larger than the new current preamble threshold, the transceiver 700 at step 909 determines that the determined CRC failure at step 905 is an actual CRC failure. In this case, the DRC information may be effected by the CRC failure. The requested data rate in the data rate control loop between the mobile station and the base station may be lowered. If the current metric is not larger than the new current preamble threshold, the transceiver 700 at step 910 determines that the CRC failure determined at step 905 is not an actual CRC failure. As a result, the DRC determination may not be effected. Accordingly, the transceiver 700 may afford to use a lower preamble threshold, even though a low preamble threshold increases false preamble detection. The issue of false CRC failure, however, is solved by comparing the preamble metric to a new threshold which is higher than the original threshold.

Those of skill in the art would further appreciate that the various illustrative logical blocks, modules, circuits, and algorithm steps described in connection with the embodiments disclosed herein may be implemented as electronic hardware, computer software, or combinations of both. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system.

The various illustrative logical blocks, modules, and circuits described in connection with the embodiments disclosed herein may be implemented or performed with a general purpose processor, a digital signal processor (DSP), an application specific integrated circuit (ASIC), a field programmable gate array (FPGA) or other programmable logic device, discrete gate or transistor logic, discrete hardware components, or any combination thereof designed to perform the functions described herein. A general-purpose processor may be a microprocessor, but in the alternative, the processor may be any conventional processor, controller, microcontroller, or state machine. A processor may also be implemented as a combination of computing devices, e.g., a combination of a DSP and a microprocessor, a plurality of microprocessors, one or more microprocessors in conjunction with a DSP core, or any other such configuration.

The steps of a method or algorithm described in connection with the embodiments disclosed herein may be embodied directly in hardware, in a software module executed by a processor, or in a combination. A software module may reside in RAM memory, flash memory, ROM memory, EPROM memory, EEPROM memory, registers, hard disk, a removable disk, a CD-ROM, or any other form of storage medium known in the art. An exemplary storage medium is coupled to the processor such that the processor can read information from, and write information to, the storage medium. In the alternative, the storage medium may be integral to the processor. The processor and the storage medium may reside in an ASIC. The ASIC may reside in a user terminal. In the alternative, the processor and the storage medium may reside as discrete components in a user terminal.

## Claims

1. A method for detecting a packet of data in a communication system (100), comprising:
determining a current preamble threshold for a current time slot associated with reception of said packet of data (801), said preamble threshold being based on a current signal-to-noise ratio;
determining a current preamble metric associated with decoding energy of a preamble of said packet of data in said current time slot, said preamble metric being an indication of an accumulated preamble energy over a length of the preamble during the current times slot (802);
determining whether a preamble is detected by comparing said current metric to said current preamble threshold (803); **characterised in that**
if a preamble is detected in the current time slot, determining whether an earlier preamble has been detected in an earlier time slot having a common time slot interlace index with the current time slot (804);
if an earlier preamble is detected, resolving multiple detections of a preamble based on at least one of said current preamble threshold, an old preamble threshold, said current preamble metric, and an old preamble metric, wherein said old preamble threshold and said old preamble metric are associated with said earlier preamble detection (805).

2. The method as recited in claim 1 further comprising:
determining said old preamble threshold based on information related to said earlier time slot.

3. The method as recited in claim 1 further comprising:
determining said old preamble metric during said earlier time slot.

4. The method as recited in claim 1 wherein said resolving includes:
determining a difference of value between said old and current preamble threshold, and if said difference value is larger than a predetermined level, selecting the preamble detection associated with the larger preamble threshold for detecting said packet of data.

5. The method as recited in claim 4 wherein said resolving includes:
if said difference value is less than said predetermined level, determining a current ratio of said current preamble metric over said current preamble threshold, and an old ration of said old preamble metric over old current preamble threshold; selecting the preamble detection associated with the larger ratio of said old and new ratios for detecting said packet of data.

6. The method as recited in claim 1, further comprising:
if a preamble is selected from said multiple detections of preamble, decoding data following said selected preamble and determining error rate of said decoded data for determining cyclic redundancy check (CRC) of said decoded data (904);
if a CRC failure is detected, determining a new current preamble threshold, wherein said new current preamble threshold is larger than said current preamble threshold, and determining whether said current preamble metric is larger than said new current preamble threshold (907);
if said current preamble metric is larger than said new current preamble threshold, determining said CRC failure as an actual CRC failure (909), and if said current preamble metric is less than said new current preamble threshold, determining said CRC failure as a false CRC failure (910).

7. An apparatus for detecting a packet of data in a communication system (100), comprising:
means for determining a current preamble threshold for a current time slot associated with reception of said packet of data, said preamble threshold being based on a current signal-to-noise ratio;
means for determining a current preamble metric associated with decoding energy of a preamble of said packet of data in said current time slot, said preamble metric being an indication of an accumulated preamble energy over a length of the preamble during the current times slot;
means for determining whether a preamble is detected by comparing said current metric to said current preamble threshold; **characterised in that** if a preamble is detected in the current time slot, means for determining whether an earlier preamble has been detected in an earlier time slot having a common time slot interlace index with the current time slot;
if an earlier preamble is detected, means for resolving multiple detections of a preamble based on at least one of said current preamble threshold, an old preamble threshold, said current preamble metric, and an old preamble metric, wherein said old preamble threshold and said old preamble metric are associated with said earlier preamble detection.

8. The apparatus as recited in claim 7 further comprising:
means for determining said old preamble threshold based on information related to said earlier time slot.

9. The apparatus as recited in claim 7 further comprising:
means for determining said old preamble metric during said earlier time slot.

10. The apparatus as recited in claim 7 wherein said means for resolving includes:
means for determining a difference of value between said old and current preamble threshold, and if said difference value is larger than a predetermined level, means for selecting the preamble detection associated with the larger preamble threshold for detecting said packet of data.

11. The apparatus as recited in claim 10 wherein said means for resolving includes:
if said difference value is less than said predetermined level, means for determining a current ratio of said current preamble metric over said current preamble threshold, and an old ration of said old preamble metric over old current preamble threshold;
means for selecting the preamble detection associated with the larger ratio of said old and new ratios for detecting said packet of data.

12. The apparatus as recited in claim 7, further comprising:
if a preamble is selected from said multiple detections of preamble, means for decoding data following said selected preamble and determining error rate of said decoded data for determining cyclic redundancy check (CRC) of said decoded data;
if a CRC failure is detected, means for determining a new current preamble threshold, wherein said new current preamble threshold is larger than said current preamble threshold, and means for determining whether said current preamble metric is larger than said new current preamble threshold;
if said current preamble metric is larger than said new current preamble threshold, means for determining said CRC failure as an actual CRC failure, and if said current preamble metric is less than said new current preamble threshold, determining said CRC failure as a false CRC failure.

## Patentansprüche

1. Ein Verfahren zum Erkennen eines Datenpakets in einem Kommunikationssystem (100), aufweisend:
Feststellen eines derzeitigen Präambel-Schwellwerts für einen derzeitigen Zeitschlitz, der einem Empfang des Datenpakets (801) zugeordnet ist, wobei der Präambel-Schwellwert auf einem derzeitigen Signal-zu-Rausch-Verhältnis basiert;
Feststellen einer derzeitigen Präambel-Metrik, die dem Dekodieren von Energie einer Präambel des Datenpakets in dem derzeitigen Zeitschlitz zugeordnet ist, wobei die Präambel-Metrik ein Hinweis einer akkumulierten Präambel-Energie über eine Länge der Präambel während des derzeitigen Zeitschlitzes (802) ist;
Feststellen, ob eine Präambel erkannt wurde durch Vergleich der derzeitigen Metrik mit dem derzeitigen Präambel-Schwellwert (803); **dadurch gekennzeichnet, dass**
wenn eine Präambel in dem derzeitigen Zeitschlitz erkannt wurde, Feststellen, ob eine frühere Präambel in einem früheren Zeitschlitz erkannt wurde, der einen gemeinsamen Zeitschlitz-Interlace-Index mit dem derzeitigen Zeitschlitz (804) hat;
wenn eine frühere Präambel erkannt wurde, Auflösen von mehreren Erkennungen einer Präambel basierend auf wenigstens einem der folgenden: dem derzeitigen Präambel-Schwellwert, einem alten Präambel-Schwellwert, der derzeitigen Präambel-Metrik und einer alten Präambel-Metrik, wobei der alte Präambel-Schwellwert und die alte Präambel-Metrik der früheren Präambel-Erkennung (805) zugeordnet sind.

2. Verfahren gemäß Anspruch 1, weiterhin aufweisend:
Feststellen des alten Präambel-Schwellwerts basierend auf Information in Bezug auf den früheren Zeitschlitz.

3. Verfahren gemäß Anspruch 1, weiterhin aufweisend:
Feststellen der früheren Präambel-Metrik während des früheren Zeitschlitzes.

4. Verfahren gemäß Anspruch 1, wobei das Auflösen umfasst:
Feststellen eines Differenzwerts zwischen dem alten und dem derzeitigen Präambel-Schwellwert und, falls der Differenzwert größer als ein vorbestimmtes Niveau ist, Auswählen der Präambel-Erkennung, die dem größeren Präambel-Schwellwert zum Erkennen des Datenpakets zugeordnet ist.

5. Verfahren gemäß Anspruch 4, wobei das Auflösen umfasst:
wenn der Differenzwert kleiner als das vorbestimmte Niveau ist, Feststellen eines derzeitigen Verhältnisses der derzeitigen Präambel-Metrik zu dem derzeitigen Präambel-Schwellwert und eines alten Verhältnisses der alten Präambel-Metrik zu dem alten derzeitigen Präambel-Schwellwert; Auswählen der Präambel-Erkennung, die dem größeren Verhältnis der alten und neuen Verhältnisse zum Erkennen der Datenpakete zugeordnet ist.

6. Verfahren gemäß Anspruch 1, weiterhin aufweisend:
wenn eine Präambel aus den mehreren Erkennungen von Präambeln ausgewählt ist, Dekodieren von Daten gemäß der ausgewählten Präambel und Feststellen einer Fehlerrate der dekodierten Daten zum Feststellen eines Cyclic Redundancy Check (CRC) der dekodierten Daten (904);
wenn ein CRC-Fehler erkannt wird, Feststellen eines neuen derzeitigen Präambel-Schwellwerts, wobei der neue derzeitige Präambel-Schwellwert größer als der derzeitige Präambel-Schwellwert ist, und Feststellen, ob die derzeitige Präambel-Metrik größer als der neue derzeitige Präambel-Schwellwert (907) ist;
wenn die derzeitige Präambel-Metrik größer als der neue derzeitige Präambel-Schwellwert ist, Feststellen des CRC-Fehlers als eines aktuellen CRC-Fehlers (909), und falls die derzeitige Präambel-Metrik kleiner ist als der neue derzeitige Präambel-Schwellwert, Feststellen des CRC-Fehlers als eines falschen CRC-Fehlers (910).

7. Vorrichtung zum Erkennen eines Datenpakets in einem Kommunikationssystem (100) aufweisend:
Mittel zum Feststellen eines derzeitigen Präambel-Schwellwerts für einen derzeitigen Zeitschlitz, der dem Empfang des Datenpakets zugeordnet ist, wobei der Präambel-Schwellwert auf einem derzeitigen Signal-zu-Rausch-Verhältnis basiert;
Mittel zum Feststellen einer derzeitigen Präambel-Metrik, welcher dem Dekodieren von Energie einer Präambel des Datenpakets in dem derzeitigen Zeitschlitz zugeordnet ist, wobei die Präambel-Metrik ein Hinweis einer akkumulierten Präambel-Energie über einer Länge der Präambel während des derzeitigen Zeitschlitzes ist;
Mittel zum Feststellen, ob eine Präambel erkannt wurde durch Vergleich der derzeitigen Metrik zu dem derzeitigen Präambel-Schwellwert; **dadurch gekennzeichnet, dass**
wenn eine Präambel in dem derzeitigen Zeitschlitz erkannt wurde, Mittel zum Feststellen, ob eine frühere Präambel in einem früheren Zeitschlitz erkannt wurde, der einen gemeinsamen Zeitschlitz-Interlace-Index mit dem derzeitigen Zeitschlitz hat;
wenn eine frühere Präambel erkannt wurde, Mittel zum Auflösen von mehreren Erkennungen einer Präambel, basierend auf wenigstens einem der folgenden: dem derzeitigen Präambel-Schwellwert, einem alten Präambel-Schwellwert, der derzeitigen Präambel-Metrik und einer alten Präambel-Metrik, wobei der Präambel-Schwellwert und die alte Präambel-Metrik der früheren Präambel-Erkennung zugeordnet sind.

8. Vorrichtung gemäß Anspruch 7, weiterhin aufweisend:
Mittel zum Feststellen des alten Präambel-Schwellwerts basierend auf Informationen in Bezug auf den früheren Zeitschlitz.

9. Vorrichtung gemäß Anspruch 7, weiterhin aufweisend:
Mittel zum Feststellen der alten Präambel-Metrik während des früheren Zeitschlitzes.

10. Vorrichtung gemäß Anspruch 7, wobei die Mittel zum Auflösen umfassen:
Mittel zum Feststellen eines Differenzwertes zwischen dem alten und dem derzeitigen Präambel-Schwellwert, und wenn der Differenzwert größer als ein vorbestimmtes Niveau ist, Mittel zum Auswählen der Präambel-Erkennung, die dem größeren Präambel-Schwellwert zum Erkennen des Datenpakets zugeordnet ist.

11. Verfahren gemäß Anspruch 10, wobei die Mittel zum Auflösen umfassen:
wenn der Differenzwert kleiner ist als das vorbestimmte Niveau, Mittel zum Feststellen eines derzeitigen Verhältnisses der derzeitigen Präambel-Metrik zu dem derzeitigen Präambel-Schwellwert und eines alten Verhältnisses der alten Präambel-Metrik zu dem alten derzeitigen Präambel-Schwellwert;
Mittel zum Auswählen der Präambel-Erkennung, die dem größeren Verhältnis der alten und neuen Verhältnisse zum Erkennen der Datenpakete zugeordnet ist.

12. Vorrichtung gemäß Anspruch 7, weiterhin aufweisend:
wenn eine Präambel aus den mehreren Erkennungen von Präambeln ausgewählt wurde, Mittel zum Dekodieren von Daten gemäß der ausgewählten Präambel und zum Feststellen einer Fehlerrate der dekodierten Daten zum Feststellen des Cylic Redundancy Checks (CRC) der dekodierten Daten;
wenn ein CRC-Fehler erkannt wurde, Mittel zum Feststellen eines neuen derzeitigen Präambel-Schwellwerts, wobei der neue derzeitige Präambel-Schwellwert größer als der derzeitige Präambel-Schwellwert ist, und Mittel zum Feststellen, ob die derzeitige Präambel-Metrik größer als der neue derzeitige Präambel-Schwellwert ist;
wenn die derzeitige Präambel-Metrik größer als der neue derzeitige Präambel-Schwellwert ist, Mittel zum Feststellen des CRC-Fehlers als eines aktuellen CRC-Fehlers und, falls die derzeitige Präambel-Metrik kleiner als der neue derzeitige Präambel-Schwellwert ist, Feststellen des CRC-Fehlers als eines falschen CRC-Fehlers.

## Revendications

1. Procédé de détection d'un paquet de données dans un système de communication (100), comprenant :
la détermination d'un seuil actuel de position de synchronisation initiale pour une tranche actuelle de temps, associée à la réception dudit paquet de données (801), ledit seuil de position de synchronisation initiale étant basé sur un rapport actuel signal / bruit ;
la détermination d'une métrique actuelle de position de synchronisation initiale, associée à l'énergie de décodage d'une position de synchronisation initiale dudit paquet de données dans ladite tranche actuelle de temps, ladite métrique de position de synchronisation initiale constituant une indication d'une énergie accumulée de position de synchronisation initiale sur une longueur de la position de synchronisation initiale pendant la tranche actuelle de temps (802) ;
la détermination de la détection, on non, d'une position de synchronisation initiale, en comparant ladite métrique actuelle audit seuil actuel de position de synchronisation initiale (803) ;
**caractérisé en ce que**
si une position de synchronisation initiale est détectée dans la tranche actuelle de temps, il est déterminé si une position précédente de synchronisation initiale a été détectée ou non dans une tranche précédente de temps, ayant un indice d'entrelacement commun de tranche de temps avec la tranche actuelle de temps (804) ;
si une position précédente de synchronisation initiale est détectée, des détections multiples d'une position de synchronisation initiale sont discriminées sur la base d'au moins l'un dudit seuil actuel de position de synchronisation initiale, d'un seuil ancien de position de synchronisation initiale, de ladite métrique actuelle de position de synchronisation initiale, et d'une métrique ancienne de position de synchronisation initiale, dans lequel ledit seuil ancien de position de synchronisation initiale et ladite métrique ancienne de position de synchronisation initiale sont associés à ladite détection de position précédente de synchronisation initiale (805).

2. Procédé selon la revendication 1, comprenant en outre :
la détermination dudit seuil ancien de position de synchronisation initiale sur la base d'informations liées à ladite tranche précédente de temps.

3. Procédé selon la revendication 1, comprenant en outre :
la détermination de ladite métrique ancienne de position de synchronisation initiale pendant ladite tranche précédente de temps.

4. Procédé selon la revendication 1, dans lequel ladite discrimination comprend :
la détermination d'une différence de valeur entre lesdits seuils ancien et actuel de position de synchronisation initiale et, si ladite valeur de la différence est supérieure à un niveau prédéterminé, la sélection de la détection de position de synchronisation initiale, qui est associée au seuil le plus élevé de position de synchronisation initiale pour la détection dudit paquet de données.

5. Procédé selon la revendication 4, dans lequel ladite discrimination comprend :
si ladite valeur de la différence est inférieure audit niveau prédéterminé, la détermination d'un rapport actuel de ladite métrique actuelle de position de synchronisation initiale audit seuil actuel de position de synchronisation initiale, et un rapport ancien de ladite métrique ancienne de position de synchronisation initiale audit seuil ancien de position de synchronisation initiale ; et la sélection de la détection de position de synchronisation initiale, qui est associée au rapport le plus élevé entre lesdits rapports ancien et nouveau, pour la détection dudit paquet de données.

6. Procédé selon la revendication 1, comprenant en outre :
si une position de synchronisation initiale est sélectionnée à partir desdites détections multiples de position de synchronisation initiale, le décodage de données faisant suite à ladite position sélectionnée de synchronisation initiale, et la détermination du taux d'erreurs desdites données décodées afin de déterminer un contrôle de redondance cyclique (CRC) desdites données décodées (904) ;
si une défaillance CRC est détectée, la détermination d'un nouveau seuil actuel de position de synchronisation initiale, dans lequel ledit nouveau seuil actuel de position de synchronisation initiale est plus élevé que ledit seuil actuel de position de synchronisation initiale, et la détermination du fait que ladite métrique actuelle de position de synchronisation initiale est plus élevée ou non que ledit nouveau seuil actuel de position de synchronisation initiale (907) ;
si ladite métrique actuelle de position de synchronisation initiale est plus élevée que ledit nouveau seuil actuel de position de synchronisation initiale, la détermination que ladite défaillance CRC est une défaillance CRC réelle (909) et, si ladite métrique actuelle de position de synchronisation initiale est inférieure audit nouveau seuil actuel de position de synchronisation initiale, la détermination que ladite défaillance CRC est une fausse défaillance CRC (910).

7. Appareil de détection d'un paquet de données dans un système de communication (100), comprenant :
des moyens de détermination d'un seuil actuel de position de synchronisation initiale pour une tranche actuelle de temps, associée à la réception dudit paquet de données, ledit seuil de position de synchronisation initiale étant basé sur un rapport actuel signal / bruit ;
des moyens de détermination d'une métrique actuelle de position de synchronisation initiale, associée à l'énergie de décodage d'une position de synchronisation initiale dudit paquet de données dans ladite tranche actuelle de temps, ladite métrique de position de synchronisation initiale constituant une indication d'une énergie accumulée de position de synchronisation initiale sur une longueur de la position de synchronisation pendant la tranche actuelle de temps ;
des moyens de détermination, pour déterminer si une position de synchronisation initiale est détectée ou non, en comparant ladite métrique actuelle audit seuil actuel de position de synchronisation initiale ;
**caractérisé en ce que**
si une position de synchronisation initiale est détectée dans la tranche actuelle de temps, des moyens sont prévus pour déterminer si une position précédente de synchronisation initiale a été détectée ou non dans une tranche précédente de temps, ayant un indice d'entrelacement commun de tranche de temps avec la tranche actuelle de temps ;
si une position précédente de synchronisation initiale est détectée, des moyens sont prévus pour discriminer des détections multiples d'une position de synchronisation initiale, sur la base d'au moins l'un dudit seuil actuel de position de synchronisation initiale, d'un seuil ancien de position de synchronisation initiale, de ladite métrique actuelle de position de synchronisation initiale, et d'une métrique ancienne de position de synchronisation initiale, dans lequel ledit seuil ancien de position de synchronisation initiale et ladite métrique ancienne de position de synchronisation initiale sont associés à ladite détection de position précédente de synchronisation initiale.

8. Appareil selon la revendication 7, comprenant en outre :
des moyens de détermination dudit seuil ancien de position de synchronisation initiale sur la base d'informations liées à ladite tranche précédente de temps.

9. Appareil selon la revendication 7, comprenant en outre :
des moyens de détermination de ladite métrique ancienne de position de synchronisation initiale pendant ladite tranche précédente de temps.

10. Appareil selon la revendication 7, dans lequel lesdits moyens de discrimination comprennent :
des moyens de détermination d'une différence de valeur entre lesdits seuils ancien et actuel de position de synchronisation initiale et, si ladite valeur de la différence est supérieure à un niveau prédéterminé, des moyens de sélection de la détection de position de synchronisation initiale, qui est associée au seuil le plus élevé de position de synchronisation initiale pour la détection dudit paquet de données.

11. Appareil selon la revendication 10, dans lequel lesdits moyens de discrimination comprennent :
si ladite valeur de la différence est inférieure audit niveau prédéterminé, des moyens de détermination d'un rapport actuel de ladite métrique actuelle de position de synchronisation initiale audit seuil actuel de position de synchronisation initiale, et d'un rapport ancien de ladite métrique ancienne de position de synchronisation initiale audit seuil ancien de position de synchronisation initiale ;
des moyens de sélection de la détection de position de synchronisation initiale, qui est associée au rapport le plus élevé entre lesdits rapports ancien et nouveau, pour la détection dudit paquet de données.

12. Appareil selon la revendication 7, comprenant en outre :
si une position de synchronisation initiale est sélectionnée à partir desdites détections multiples de position de synchronisation initiale, des moyens de décodage de données faisant suite à ladite position sélectionnée de synchronisation initiale, et de détermination du taux d'erreurs desdites données décodées afin de déterminer un contrôle de redondance cyclique (CRC) desdites données décodées ;
si une défaillance CRC est détectée, des moyens de détermination d'un nouveau seuil actuel de position de synchronisation initiale, dans lequel ledit nouveau seuil actuel de position de synchronisation initiale est plus élevé que ledit seuil actuel de position de synchronisation initiale, et des moyens de détermination du fait que ladite métrique actuelle de position de synchronisation initiale est plus élevée ou non que ledit nouveau seuil actuel de position de synchronisation initiale ;
si ladite métrique actuelle de position de synchronisation initiale est plus élevée que ledit nouveau seuil actuel de position de synchronisation initiale, des moyens de détermination que ladite défaillance CRC est une défaillance CRC réelle et, si ladite métrique actuelle de position de synchronisation initiale est inférieure audit nouveau seuil actuel de position de synchronisation initiale, de détermination que ladite défaillance CRC est une fausse défaillance CRC.
